Europäisches Patentamt

European Patent Office

Office européen des brevets

(11) Publication number: **0 088 890**
**B1**

(12) **EUROPEAN PATENT SPECIFICATION**

(45) Date of publication of patent specification: **13.06.90**

(51) Int. Cl.⁵: **H 01 J 37/26**

(21) Application number: **83101275.2**

(22) Date of filing: **10.02.83**

(54) Electron holography microscope.

(30) Priority: **12.03.82 JP 38013/82**

(43) Date of publication of application:
**21.09.83 Bulletin 83/38**

(45) Publication of the grant of the patent:
**13.06.90 Bulletin 90/24**

(84) Designated Contracting States:
**DE FR GB**

(56) References cited:

APPLIED OPTICS, vol. 18, no. 8, April 1979,
pages 1275-1280, New York, US; S. YOKOZEKI
et al.: "Moiré interferometry"

JOURNAL OF PHYSICS E-SCIENTIFIC
INSTRUMENTS, vol. 14, no. 6, June 1981, pages
649-671, Dorking, GB; G.F. MISSIROLI et al.:
"Electron interferometry and inteference
electron microscopy"

The file contains technical information
submitted after the application was filed and
not included in this specification

(73) Proprietor: **Hitachi, Ltd.**
**5-1, Marunouchi 1-chome**
**Chiyoda-ku Tokyo 100 (JP)**

(72) Inventor: **Nomura, Setsuo**
**2196-414, Hirai Hinodemachi**
**Nishitama-gun Tokyo (JP)**
Inventor: **Tonomura, Akira**
**1-1-10, Nukuiminami-cho**
**Koganei-shi Tokyo (JP)**
Inventor: **Hamamoto, Nobuo**
**2196-344, Hirai Hinodemachi**
**Nishitama-gun Tokyo (JP)**
Inventor: **Fukuhara, Akira**
**625-3, Nagafusa-cho**
**Hachioji-shi Tokyo (JP)**

(74) Representative: **Altenburg, Udo, Dipl.-Phys.**
**et al**
**Patent- und Rechtsanwälte Bardehle-**
**Pagenberg-Dost-Altenburg & Partner Postfach**
**86 06 20**
**D-8000 München 86 (DE)**

**EP 0 088 890 B1**

56 References cited:
OPTIK, vol. 44, no. 4, 1975, pages 457-461,
Wissenschaftliche Verlagsgesellschaft mbH,
Stuttgart, DE; L.H. VENEKLASEN: "On line
holographic imaging in the scanning
transmission electron microscope"

## Description

The present invention relates to an electron holography microscope which affords the phase information of the three-dimensional structure, magnetic domain structure, etc. of a spectrum on the basis of the electron holography method.

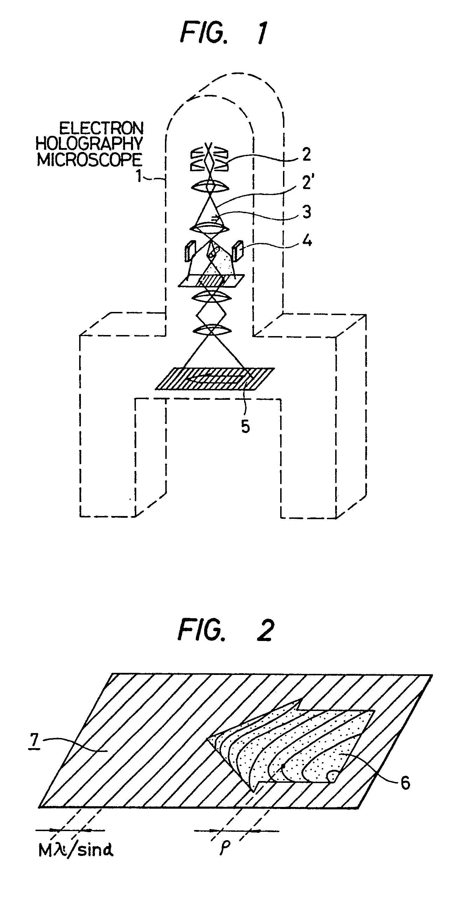

Recently, holography has been realized in the field of electron microscopes similarly to the field of light, owing to the fact that a high-brightness electron gun represented by a field-emission electron gun has been put into practical use. The electron beam holography is such that, as shown in Figure 1, an electron beam 2' emergent from a high-brightness electron gun 2 in an electron microscope housing 1 is divided by an electron beam prism 4 into a specimen electron beam transmitted through a specimen 3 and containing the information of this specimen, and a reference electron beam passing outside the specimen and serving as the reference of an electron beam phase, whereupon the electron beams are caused to interfere on the focusing plane of the electron microscope so as to form an electron beam hologram image 5. As a result, a fringe pattern called the hologram as shown in Figure 2 appears on the focusing plane of the electron microscope, in superposition on a fine specimen image 6 having hitherto been available. Whereas the conventional electron microscope specimen image 6 is the two-dimensional shadow image of the specimen, the fringe pattern gives three-dimensional information related with electron beam shift in the specimen. More specifically, the hologram image 7 of the part outside the specimen is a fringe pattern of straight lines having a period of M $\lambda$/sin $\alpha$ (M: magnification of the electron microscope, $\lambda$: wavelength of the electron beam, $\alpha$: tilting angle of the electron beam) as shown in Figure 2. In contrast, the hologram image of the part transmitted through the specimen deviates from the straight lines. The deviation is attributed to the fact that the electron beam has its phase disordered when transmitted through the specimen. The quantity $\delta$ of the deviation is proportional to, e.g., the thickness $t$ of the specimen in the corresponding part. Accordingly, when those parts in the hologram image in which the quantities of the deviation are a fixed value are traced, a contour line map concerning the thickness of the specimen is obtained, and the three-dimensional structure is known even in the microscopic world of the electron microscope.

In the prior-art electron holography microscope, very complicated operations have been performed in order to obtain the contour line map because the hologram image is formed by the electron beam in the vacuum microscope housing. More specifically, in the first place, the electron beam hologram image is recorded on a photographic film in the vacuum camera chamber of the electron microscope, and the photographic film is taken out of the electron microscope. This photographic film is developed, fixed and dried in a darkroom, to obtain a hologram film which can be optically processed. Next, this film is set on a holographic picture reconstructing apparatus which employs a laser source and an optical lens-system as well as an optical prism. The conditions of the interference of the laser beam are adjusted, to obtain a reconstructed hologram image which expresses the contour line map. Thus, the series of operations have required a period of time of nearly one day or more and complicated labors such as the darkroom operations and the adjustments of the holographic picture reconstructing apparatus. Especially the disadvantage that the long time is taken before the contour line map is obtained, has been fatal in, for example, a case where the three-dimensional structural variation of the specimen is desired to be investigated immediately.

An electron holography microscope is knwon from "Journal of Physics E: "Scientific Instruments" 14 (1981), pages 649—671, in particular fig. 11 and 12. There is explained the possibility of separating in an optical bench the phase and amplitude terms of the object wave function by interference between the optically reconstructed wave and a plane wave (holographic interferometry). The interferograms for the detection of the object phase distribution have been produced by superimposing to the region of interest of the hologram a plane wave obtained from a portion of the same interference fringe system corresponding to a region without a specimen. A system of holographic interference fringes is visible in the reconstructed image; a maximum phase shift of about 3 $\pi$ can be measured corresponding to the thickest part of the specimen.

A similar optical reconstruction of the phase information of an electron hologram image was explained above. In such optical bench reconstructions a plane wave is superimposed on the conventional electron hologram image to get a contour line map.

The optical and photographic procedures are time-consuming and complicated. Accordingly it is the object of the invention to provide for an electron holography microscope which offers a contour line map of a specimen immediately. This object is accomplished by the features of claim 1.

Due to the invention an electronic superposition is implemented to achieve the contour line map. For the electronic reconstruction a basic fringe is produced in a specific way to be superimposed on the conventional hologram fringe.

For obtaining the basic fringes for an electron holography microscope, it is not sufficient to adopt the electronic signal processing due to "Applied Optics" 18 (1979), pages 1279—1280. From this document a Moiré techniques as such, a camera for producing an electronic image representation of the conventional hologram image, an image multiplier and a monitor display are known, but the device is only used in connection with optical holography microscope images, and the reference or initial state interferogram which corresponds to the basic fringe of the present invention is only memorized by a video tape recorder.

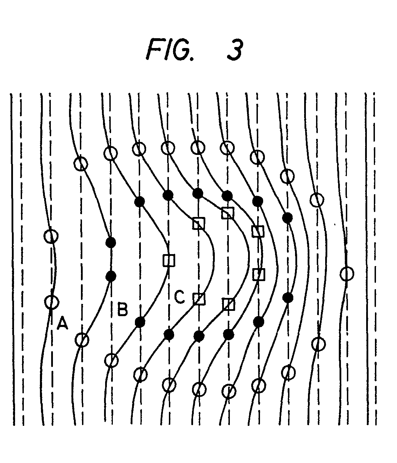

In order to accomplish the object, in the electron holography microscope of the present invention, first of all, an electron beam hologram image is formed on a fluorescent screen and is picked up by a television camera. Next, note is taken of the fact that moire fringes of long period, which arises when two fine fringe patterns are superposed, can be utilized for tracing places where the quantities of deviation of hologram fringes are a fixed value. That is, when fine fringes extending in quite the same direction as that of hologram fringes arising outside a specimen are prepared and superposed on hologram fringes obtained from the specimen, places of a fixed deviation value appear as the points of intersection between the two fringe patterns, and the intersection points are observed by human eyes as a moire fringe indicating a contour line map. The aforementioned fine fringes (hereinbelow, termed the "basic fringes") are used as, so to speak, a scale for normalizing the quantities of deviation. When the situation in which the moire fringes indicative of the contour line map are depicted as in Figure 3, conditions required for the basic fringes are understood. The conditions are that the direction of the basic fringes is quite identical to the direction of the hologram fringes of the part outside the specimen, and that the period of the former is equal to, or 1/n(n;integer) of, the period of the latter. In Figure 3, solid lines depict the hologram fringes typically, while dotted lines depict the basic fringes. As a result, the points of intersection between the two fine fringes, namely, parts indicated by marks $\bigcirc$, $\bullet$ and $\square$ in the figure respectively, are visually recognized as lines (moire fringes).

The hologram image is picked up by the television camera, as is converted into an electric signal in advance. Then, the electrical superposition of the pattern of the basic fringes on the resulting picture is permitted by operating a signal multiplier and a switching circuit in synchronism with the scanning of picture elements. The basic fringe pattern can be electrically formed by the use of, for example, a sinusoidal wave generator circuit. Further, the hologram fringes of the part outside the specimen have the fringe pattern which is quite the same in both the direction and the period as that of hologram fringes arising in the absence of the specimen. Therefore, when the hologram fringes are picked up by the television camera without the specimen and are stored in an image storage device in advance, the stored image can be utilized.

Brief Description of the Drawings:

Figure 1 is a constructional view of a prior-art electron holography microscope;

Figure 2 shows an electron beam hologram image viewed obliquely from above;

Figure 3 shows a hologram image with contour lines depicted in accordance with the present invention; and

Figure 4 is a constructional view of an embodiment of an electron holography microscope according to the present invention.

Now, a practicable embodiment of the present invention will be described.

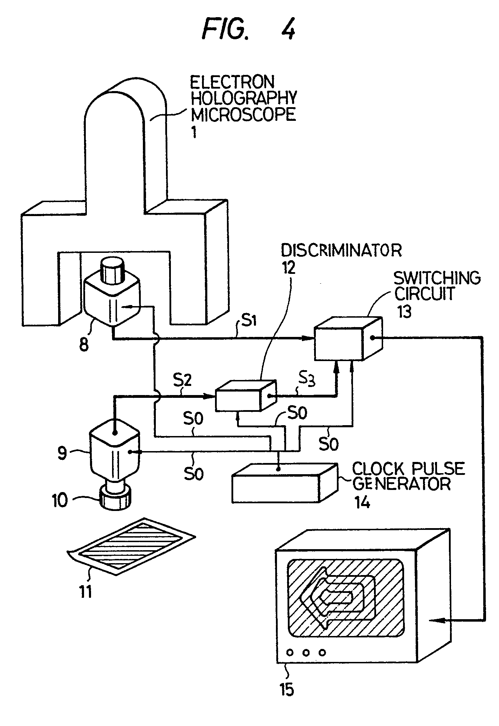

Figure 4 shows an embodiment of the present invention in the case where, in order to generate a basic fringe pattern, basic fringes depicted on chart paper 11 have been picked up by a second television camera 9. The output signal $S_2$ of the television camera 9 is compared with a certain threshold value by a discriminator 12. When the signal $S_2$ is larger, the discriminator provides the binary signal $S_3$ of "1", and when smaller, it provides the binary signals $S_3$ of "O". A hologram image signal $S_1$ picked up through the window of the housing 1 of an electron microscope by a first television camera 8, and the binary-coded signal $S_3$ picked up by the television camera 9 enter a switching circuit 13 synchronously. A clock pulse generator 14 supplies the television cameras 8, 9, the discriminator 12 and the switching circuit 13 with a clock pulse signal $S_0$ so as to synchronize them. At $S_3 = 1$, that is, when the bright part of the basic fringes has become greater than the threshold value, the switching circuit 13 passes the hologram image signal $S_1$ therethrough as it is and puts it into a monitor 15. On the other hand, at $S_3 = 0$ at which the dark part of the basic fringes has become smaller than the threshold value, the corresponding hologram image signal $S_1$ is modulated to zero, which is put into the monitor 15. The period of the basic fringes can be selected at will in such a way that a zoom lens 10 mounted on the television camera 9 is adjusted to vary the image magnification. The direction of the basic fringes can be adjusted by rotating either the televison camera 9 or the chart paper 11 being an object.

With this method, the basic fringes and the hologram fringes of the part outside the specimen are in quite the same direction in principle, so that no problem occurs even when the direction of the fringes has changed at the time of, e.g., the change of the magnification of the electron microscope. Further, unlike the contour line map in the prior-art electron holography method, the contour line map in the electron holography microscope of the present invention manifests the fine fringe pattern of the basic fringes in addition to the contour pattern. Since however, the fine fringe pattern utterly differs in the spatial frequency from the moire fringes indicative of the contour lines, it can be removed by an image processing technique employing a computer.

**Claims**

1. An electron holography microscope producing a hologram image of a specimen, characterized by

a) a television camera (8) for producing an electrical output signal (S1) by scanning the hologram image (6, 7);

b) a straight line fringe image generator (9, 10, 11, 12) which allows to select a direction and an interval of a straight line-shaped fringe pattern (11) at will, comprising a discriminator which transforms the analog signal (S2) corresponding to said straight line fringes into a binary output signal (S3);

c) means for multiplying (13) the analog electrical output signal (S1) of the television camera (8) and the binary output signal (S3) of the straight line fringe image generator (9, 10, 11, 12);

d) means for displaying (15) the result of the multiplying.

2. An electron holography microscope according to claim 1, characterized in that the straight line fringe image generator comprises a chart paper (11) representing a straight line fringe pattern and another television camera (9, 10) which picks up an image of the straight line fringe pattern.

**Patentansprüche**

1. Holographie-Elektronenmikroskop zum Erzeugen eines Hologrammbildes einer Probe, gekennzeichnet durch

a) eine Fernsehkamera (8) zum Erzeugen eines elektrischen Ausgangsiganls (S1) durch Abtasten des Hologrammbildes (6, 7);

b) eine Erzeugungseinrichtung (9, 10, 11, 12) eines geradlinigen Streifenbildes, welche die Auswahl einer Richtung und eines Intervalls eines geradlinienförmigen Streifenmusters (11) nach Belieben ermöglicht, mit einem Diskriminator, welcher das analoge Signal (S2) entsprechend den geradlinigen Streifen in ein binäres Ausgangssignal (S3) umformt;

c) Einrichtungen (13) zum Multiplizieren des analogen elektrischen Ausgangssignals (S1) der Fernsehkamera (8) und des binären Ausgangssignals (S3) der Erzeugungseinrichtung (9, 10, 11, 12) des geradlinigen Streifenbildes;

d) Einrichtungen (15) zum Anzeigen des Ergebnisses des Multiplizierens.

2. Holographie-Elektronenmikroskop gemäß Anspruch 1, dadurch gekennzeichnet, daß die Erzeugungseinrichtung des geradlinigen Streifenbildes ein Diagrammpapier (11), welches ein geradliniges Streifenmuster darstellt und eine andere Fernsehkamera (9, 10) aufweist, welche ein Bild des geradlinigen Streifenmusters aufnimmt.

**Revendications**

1. Microscope électronique holographique produisant une image holographique d'un échantillon, caractérisé par

a) une caméra de télévision (8) servant à produire un signal de sortie électrique (S1), par balayage de l'image homographique (6, 7);

b) un générateur (9, 10, 11, 12) d'images de franges formées de traits rectilignes, qui permet de sélectionner à vorlonté une direction et un intervalle d'un diagramme (11) de franges formées de traits rectilignes et comporte un discriminateur transformant le signal analogique (S2) correspondant auxdites franges formées de traits rectilignes en un signal de sortie binaire (S3);

c) des moyens (13) pour multiplier le signal de sortie électrique analogique (S1) de la caméra de télévision (8) et le signal de sortie binaire (S3) du générateur (9, 10, 11, 12) d'images de franges formées de traits rectilignes;

d) des moyens (15) pour afficher le résultat de la multiplication.

2. Microscope électronique holographique selon la revendication 1, caractérisé en ce que le générateur d'images de franges formées de traits rectilignes comprend un papier graphique (11) représentant un diagramme de franges formées de traits rectilignes, et une autre caméra de télévision (9, 10), qui détecte une image du diagramme de franges formées de traits rectilignes.

## FIG. 1

ELECTRON
HOLOGRAPHY
MICROSCOPE

## FIG. 2

$M\lambda/\sin\alpha$

$P$

FIG. 3

## FIG. 4

ELECTRON
HOLOGRAPHY
MICROSCOPE
1

DISCRIMINATOR
12

SWITCHING
CIRCUIT
13

8

S1

S2

S3

S0

S0

9

S0

S0

10

CLOCK PULSE
GENERATOR
14

11

15

3